# EUROPEAN PATENT APPLICATION

(11) **EP 4 770 322 A1**
(43) Date of publication of application: **01.07.2026**
(21) Application number: 25199609.6
(22) Date of filing: 02.09.2025
(51) Int. Cl.: H10D 30/66, H10D 62/10, H10D 84/00, H10D 62/13, H10D 62/832

(54) **SEMICONDUCTOR DEVICE**

(30) Priority: 26.12.2024 KR 20240197472
(71) Applicant: Samsung Electronics Co., Ltd., Suwon-si, Gyeonggi-do 16677 (KR)
(72) Inventor: KIM, Taehun, Suwon-si (KR); WOO, Sangsu, Suwon-si (KR); PARK, Young Hwan, Suwon-si (KR); PARK, Jeonghwan, Suwon-si (KR); OH, Sewoong, Suwon-si (KR)
(74) Representative: Marks & Clerk LLP

(57) **Abstract**

A semiconductor device comprising: a substrate including first and second surfaces; a first conductivity type semiconductor layer on the first surface; a second conductivity type doped well region within the first conductivity type semiconductor layer; a gate electrode on the first conductivity type semiconductor layer; a gate insulating layer between the first conductivity type semiconductor layer and the gate electrode; a first conductivity type doping pattern within the second conductivity type doped well region and including a first portion overlapping and electrically connected to a contact portion of a source electrode, a second portion adjacent to the gate electrode, and a third portion connecting the first and second portions; and a drain electrode on the second surface, wherein a width of the first portion is less than a length of the contact portion, or a width of the second portion is less than a length of the gate electrode.

## Description

### BACKGROUND

### 1. Field

The present disclosure relates to a semiconductor device.

### 2. Description of the Related Art

In modern society, semiconductor devices are closely related to our daily lives. In particular, the importance of power semiconductor devices used in various fields such as transportation such as electric vehicles, railways, and electric trams, renewable energy systems such as solar power generation and wind power generation, and mobile devices is gradually increasing. Power semiconductor devices are semiconductor devices used to handle high voltage or high current, and perform functions such as power conversion and control in large power systems or high-power electronic devices. Power semiconductor devices have the ability to handle high power and durability, allowing them to handle large amounts of current and withstand high voltages. For example, power semiconductor devices may handle voltages from hundreds to thousands of volts and currents from tens to thousands of amperes. Power semiconductor devices may improve the efficiency of electrical energy by minimizing power loss. Additionally, power semiconductor devices may operate stably even in environments such as high temperatures.

These power semiconductor devices may be classified by material, for example, there are SiC power semiconductor devices and GaN power semiconductor devices. By manufacturing power semiconductor devices using SiC or GaN instead of existing silicon wafers (Si wafers), the shortcomings of silicon, which has unstable characteristics at high temperatures, may be complemented. SiC power semiconductor devices are resistant to high temperatures and have low power loss, making them suitable for electric vehicles and renewable energy systems. GaN power semiconductor devices are expensive but efficient in terms of speed, making them suitable for fast charging of mobile devices.

### SUMMARY

Aspects of the disclosed embodiments provide a semiconductor device with stable electric characteristics and improved reliability.

According to an embodiment, a semiconductor device comprising: a substrate including a first surface and a second surface opposite to each other; a first conductivity type semiconductor layer positioned on the first surface of the substrate; a second conductivity type doped well region positioned within the first conductivity type semiconductor layer; a gate electrode positioned on the first conductivity type semiconductor layer; a gate insulating layer positioned between the first conductivity type semiconductor layer and the gate electrode; a first conductivity type doping pattern positioned within the second conductivity type doped well region; a source electrode positioned on the second conductivity type doped well region and including a contact portion electrically connected to the first conductivity type doping pattern, and a drain electrode positioned on the second surface of the substrate, wherein the first conductivity type doping pattern includes: a first portion extending in a first direction and overlapping the contact portion of the source electrode, a second portion extending in the first direction and positioned adjacent to the gate electrode, and a third portion connecting the first portion and the second portion, and wherein a width of the first portion in a second direction is less than a length in the second direction of the contact portion, or a width of the second portion in the second direction is less than a length in the second direction of the gate electrode, the second direction being perpendicular to the first direction.

According to an embodiment, a semiconductor device comprising: a substrate including a first surface and a second surface opposite to each other; a first conductivity type semiconductor layer positioned on the first surface of the substrate; a second conductivity type doped well region positioned within the first conductivity type semiconductor layer; a first conductivity type doping pattern positioned within the second conductivity type doped well region; a gate electrode positioned on the first conductivity type semiconductor layer; a gate insulating layer positioned between the first conductivity type semiconductor layer and the gate electrode; a source electrode including a contact portion positioned on the second conductivity type doped well region; and a drain electrode positioned on the second surface of the substrate, wherein the first conductivity type doping pattern includes: a first portion overlapping the contact portion of the source electrode and extending in a first direction; a second portion overlapping the gate electrode and extending in the first direction, and a third portion connecting the first portion and the second portion and extending in a second direction intersecting the first direction, and wherein a sum of lengths of the first portion in the first direction, the second portion in the first direction, and the third portion in the second direction is greater than a length of the source electrode in the second direction.

According to an embodiment, a semiconductor device comprising: a substrate including a first surface and a second surface opposite to each other; a first conductivity type semiconductor layer positioned on the first surface of the substrate and including a gate trench; a second conductivity type doped well region positioned within the first conductivity type semiconductor layer; a first conductivity type doping pattern positioned within the second conductivity type doped well region; a dummy pattern positioned within the first conductivity type doping pattern; a gate electrode positioned within the gate trench; a gate insulating layer positioned between the first conductivity type semiconductor layer and the gate electrode; a source electrode including a contact portion positioned on the second conductivity type doped well region; and a drain electrode positioned on the second surface of the substrate; wherein the first conductivity type doping pattern includes: a first vertical portion overlapping the contact portion, a second vertical portion positioned on one side of the gate electrode and not overlapping with the contact portion, and a horizontal portion connecting the first vertical portion and the second vertical portion, and wherein the dummy pattern is positioned between the first vertical portion and the second vertical portion.

According to embodiments, the reliability of semiconductor devices may be improved.

At least some of the above and other features of the invention are set out in the claims.

### BRIEF DESCRIPTION OF THE DRAWINGS

FIG. 1 is a plan view showing a semiconductor device according to an example embodiment.
FIG. 2 is a cross-sectional view taken along line A-A' of FIG. 1.
FIG. 3 is a cross-sectional view taken along line B-B' of FIG. 1.
FIG. 4 is a cross-sectional view taken along line C-C' of FIG. 1.
FIG. 5 is a plan view showing the arrangement of a first conductivity type doping pattern of a semiconductor device according to an example embodiment.
FIG. 6 is a plan view showing the flow of driving current of a semiconductor device according to an example embodiment.
FIG. 7 is a plan view showing the arrangement of a first conductivity type doping pattern of a semiconductor device according to some example embodiments.
FIGS. 8 to 12 are plan views illustrating semiconductor devices according to some example embodiments.
FIGS. 13 to 17 are cross-sectional views illustrating semiconductor devices according to some example embodiments.

### DETAILED DESCRIPTION

Hereinafter, various embodiments will be described in detail with reference to the attached drawings so that a person having ordinary skill in the art to which the present disclosure pertains may easily implement the inventive concept. The present inventive concept may be embodied in many different forms and is not limited to the embodiments described herein.

In order to clearly explain the present disclosure, parts irrelevant to the description are omitted, and the same reference numerals are used for identical or similar components throughout the specification.

In addition, the size and the thickness of each component shown in the drawings are arbitrarily shown for convenience of explanation, so the embodiments are not necessarily limited to what is shown. To clearly represent the various layers and areas in the drawing, the thickness is enlarged and shown. And in the drawings, for convenience of explanation, the thickness of some layers and areas is exaggerated.

Also, when we say that a part, such as a layer, membrane, region, or plate, is "over" or "on" another part, this includes not only cases where it is "directly over" the other part, but also cases where there are other parts in between. Conversely, when we say that a part is "directly above" another part, we mean that there is no other part in between. Also, being "above" or "on" a reference part means being located above or below the reference part, and does not necessarily mean being located "above" or "on" the opposite direction of gravity.

It will be understood that when an element is referred to as being "connected" or "coupled" to or "on" another element, it can be directly connected or coupled to or on the other element or intervening elements may be present. In contrast, when an element is referred to as being "directly connected" or "directly coupled" to another element, or as "contacting" or "in contact with" another element (or using any form of the word "contact"), there are no intervening elements present at the point of contact.

Additionally, throughout the specification, whenever a part is said to "include" a component, this does not mean that it excludes other components, but rather that it may include other components, unless otherwise specifically stated.

Additionally, throughout the specification, when we say "in plan", we mean when the target portion is viewed from above, and when we say "in cross section", we mean when the target portion is viewed from the side in a cross-section cut vertically.

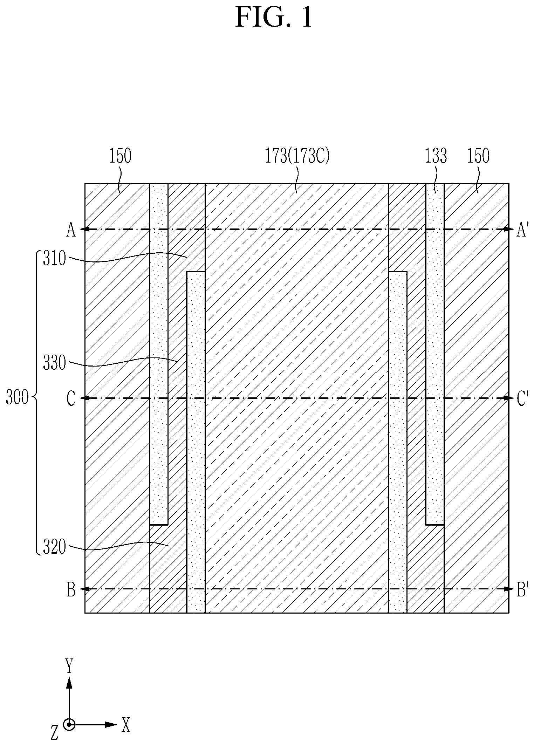

Hereinafter, a semiconductor device according to an example embodiment will be described with reference to FIGS. 1 to 4.

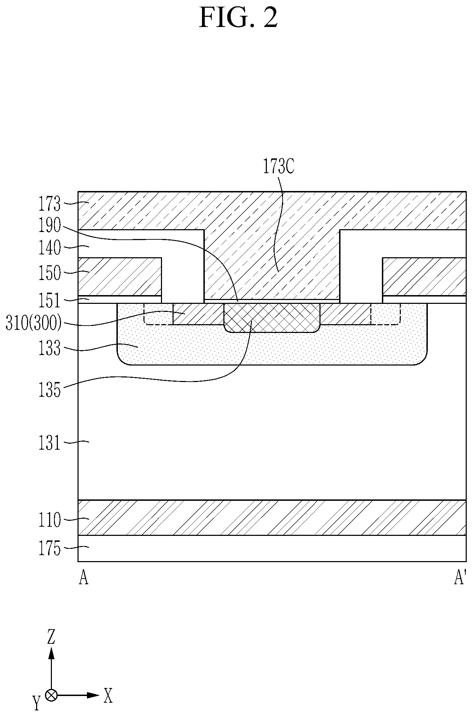

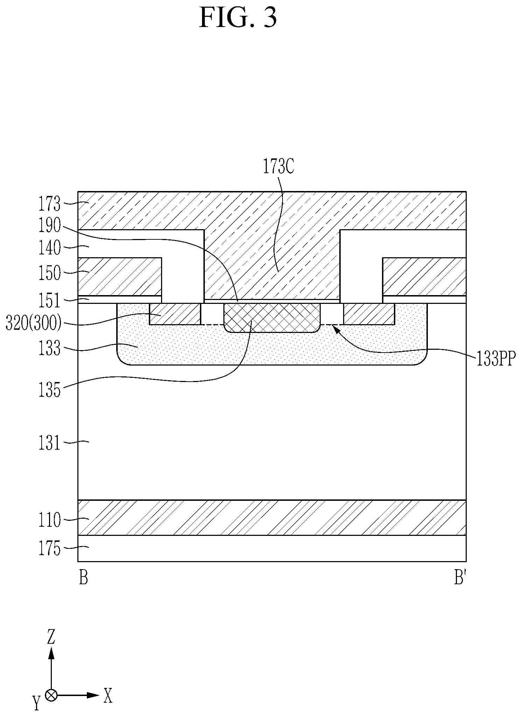

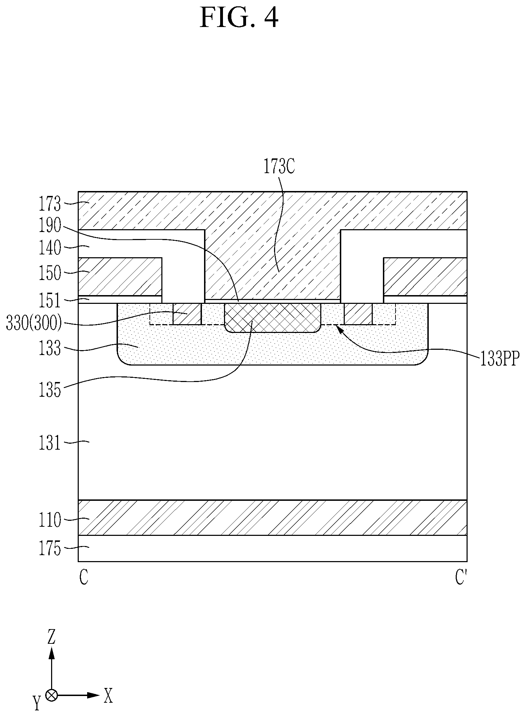

FIG. 1 is a plan view showing a semiconductor device according to an example embodiment. FIG. 2 is a cross-sectional view taken along line A-A' of FIG. 1. FIG. 3 is a cross-sectional view taken along line B-B' of FIG. 1. FIG. 4 is a cross-sectional view taken along line C-C' of FIG. 1.

Referring to FIGS. 1 to 4, a semiconductor device according to an embodiment may include a substrate 110, a first conductivity type semiconductor layer 131 positioned on a first surface of the substrate 110, a second conductivity type doped well region 133 positioned in the first conductivity type semiconductor layer 131, a gate electrode 150 positioned on the first conductivity type semiconductor layer 131, a gate insulating layer 151 positioned between the first conductivity type semiconductor layer 131 and the gate electrode 150, a first conductivity type doping pattern 300 positioned in the second conductivity type doped well region 133, a source electrode 173 positioned on the second conductivity type doped well region 133, and a drain electrode 175 positioned on the second surface of the substrate 110.

The substrate 110 may be a semiconductor substrate including SiC. For example, the substrate 110 may be made of a 4H SiC substrate. In some cases, the substrate 110 may be made of a 3C SiC substrate, a 6H SiC substrate, etc. The substrate 110 may be doped with a first conductivity type impurity. For example, the first conductivity type impurity may be an n-type. In other words, the substrate 110 may be doped with an n-type impurity. The substrate 110 may be heavily doped with the n-type impurity. The resistivity of the substrate 110 may be about 0.005Ωcm or more and about 0.035Ωcm or less. The thickness of the substrate 110 may be about 10 µm or more and about 700 µm or less. The material, doping type, doping concentration, resistivity, thickness, etc. of the substrate 110 are not limited thereto and may be changed in various ways.

The substrate 110 may include a first surface and a second surface opposite each other. For example, the first side of the substrate 110 may mean the upper side of the substrate 110, and the second side of the substrate 110 may mean the lower side of the substrate 110.

The first conductivity type semiconductor layer 131 may be positioned on the first surface, e.g., the upper surface, of the substrate 110. The lower surface of the first conductivity type semiconductor layer 131 may be in contact with the upper surface of the substrate 110. But example embodiments are not limited thereto, and another layer may be additionally positioned between the substrate 110 and the first conductivity type semiconductor layer 131. The first conductivity type semiconductor layer 131 may be an epitaxial layer formed from a substrate 110 using an epitaxial growth method. The first conductivity type semiconductor layer 131 may be formed of or include SiC. For example, the first conductivity type semiconductor layer 131 may be formed of or include 4H SiC. The first conductivity type semiconductor layer 131 may be doped with an n-type impurity. The first conductivity type semiconductor layer 131 may be lightly doped with an n-type impurity. The doping concentration of the first conductivity type semiconductor layer 131 may be lower than the doping concentration of the substrate 110. The doping concentration of the first conductivity type semiconductor layer 131 may be about 1*10¹⁵cm⁻³ or more and about 1*10¹⁷cm⁻³ or less. The thickness of the first conductivity type semiconductor layer 131 may be about 1 µm or more and about 13 µm or less.

The second conductivity type doped well region 133 may be positioned within the first conductivity type semiconductor layer 131. The second conductivity type doped well region 133 may be positioned in the upper portion of the first conductivity type semiconductor layer 131. The second conductivity type doped well region 133 may be in contact with the lower surface of the second conductivity type doped layer 135 to be described later. The second conductivity type doped well region 133 may surround the lower surface and side surface of the first conductivity type doping pattern 300 to be described later. An upper surface of the second conductivity type doped well region 133 may be coplanar with an upper surface of the first conductivity type semiconductor layer 131. In an embodiment, at least a portion of an upper surface of the second conductivity type doped well region 133 may overlap at least a portion of a gate electrode 150 to be described later and at least a portion of a gate insulating layer 151 to be described later in a third direction (Z direction). Here, the third direction (Z direction) may mean a thickness direction of the substrate 110 and/or a vertical direction perpendicular to the first surface of the substrate 110.

In an embodiment, the second conductivity type doped well region 133 may be used as the channel of a transistor constituting a semiconductor device. For example, a portion of the second conductivity type doped well region 133 adjacent to the gate electrode 150 to be described later may function as a channel of the transistor. The second conductivity type doped well region 133 that functions as a channel of the transistor may be positioned between the first conductivity type semiconductor layer 131 and the first conductivity type doping pattern 300 to be described later. In other words, a current path may be formed from the source electrode 173 to the drain electrode 175 in at least a portion of the second conductivity type doped well region 133. For convenience of explanation, the portion of the second conductivity type doped well region 133 adjacent to the gate electrode 150 that functions as the channel of the transistor is referred to as the channel region.

In an embodiment, the second conductivity type doped well region 133 may extend from the upper surface of the first conductivity type semiconductor layer 131 toward the lower surface of the first conductivity type semiconductor layer 131. That is, the second conductivity type doped well region 133 may extend in the third direction (Z direction) from the upper surface of the first conductivity type semiconductor layer 131. The second conductivity type doped well region 133 may be formed in at least a portion of the first conductivity type semiconductor layer 131 through ion implantation, but example embodiments are not limited thereto.

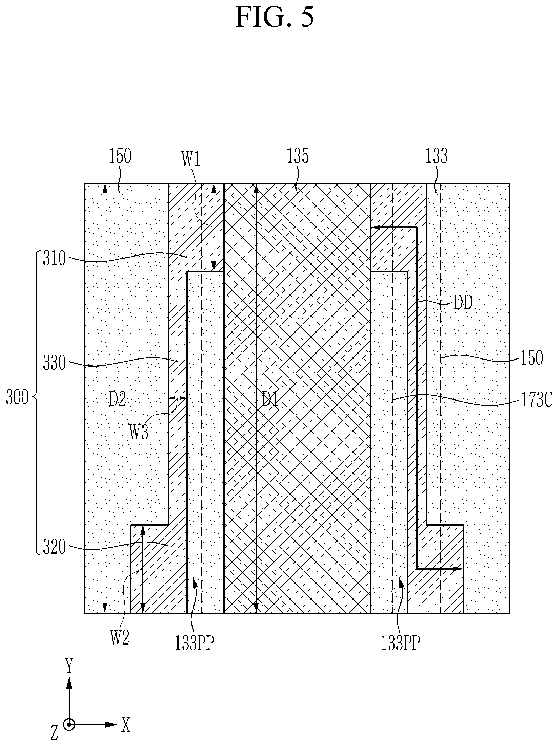

In an embodiment, the second conductivity type doped well region 133 may include a patterned portion 133PP positioned between the second conductivity type doped layer 135 to be described later and the first portion 310 of the first conductivity type doping pattern 300 to be described later. The patterned portion 133PP may refer to a portion of a second conductivity type doped well region 133 positioned between a second conductivity type doped layer 135 to be described later and a first portion 310 of a first conductivity type doping pattern 300 to be described later. A specific description of this will be provided later in the description of the first conductivity type doping pattern 300 with further reference to FIG. 5.

The second conductivity type doped well region 133 may be formed of or include SiC. For example, the second conductivity type doped well region 133 may include 4H SiC. The second conductivity type doped well region 133 may be doped with a p-type impurity. The second conductivity type doped well region 133 may be lightly doped with a p-type impurity. The doping concentration of the second conductivity type doped well region 133 may be about 1*10¹⁷cm⁻³ or more and about 1*10¹⁹cm⁻³ or less. The material, doping type, doping concentration, etc. of the second conductivity type doped well region 133 are not limited thereto and may be changed in various ways.

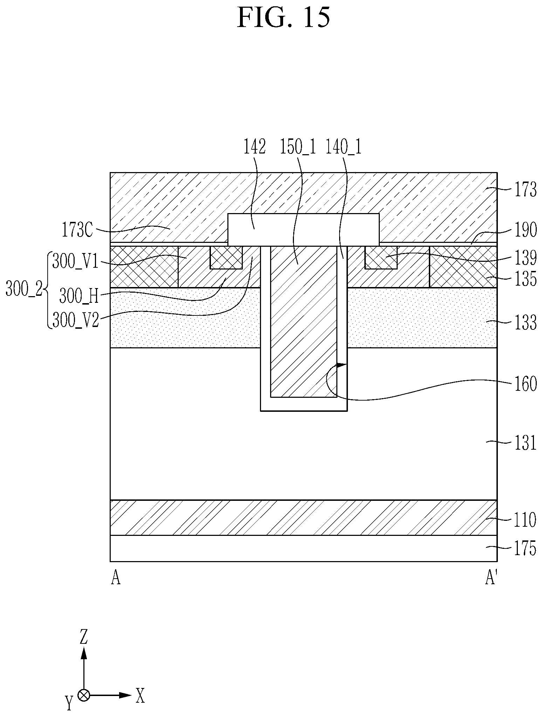

The gate electrode 150 may be positioned on the first conductivity type semiconductor layer 131. The gate electrode 150 may be spaced apart from the first conductivity type semiconductor layer 131. For example, the gate electrode 150 may be spaced apart from the first conductivity type semiconductor layer 131 in the third direction (Z direction) by a gate insulating layer 151. A semiconductor device according to an embodiment may have a planar-shaped gate structure. That is, in the semiconductor device according to the embodiment, the gate electrode 150 has a flat plate shape with an upper surface and a lower surface, and the lower surface of the gate electrode 150 may be positioned at a higher level than the uppermost surface of the first conductivity type semiconductor layer 131. But example embodiments are not limited thereto, and the semiconductor device according to the embodiment may have a trench-shaped gate structure. For example, in a semiconductor device according to an embodiment, a trench of a predetermined depth may be formed in a first conductivity type semiconductor layer 131, and a gate electrode 150 may be positioned spaced apart from the first conductivity type semiconductor layer 131 in a third direction (Z direction) within the trench. Additionally, the gate electrode 150 may be positioned spaced apart from the first conductivity type semiconductor layer 131 in the first direction (X direction). An explanation of this will be given later with reference to FIGS. 15 to 17.

A semiconductor device according to an embodiment may include a plurality of gate electrodes 150 arranged spaced apart in a first direction (X direction). For example, a plurality of gate electrodes 150 may be arranged to extend lengthwise in the second direction (Y direction) and be spaced apart in the first direction (X direction).

In an embodiment, the gate electrode 150 may overlap the second conductivity type doped well region 133 and at least a portion of the first conductivity type doping pattern 300 to be described later in the third direction (Z direction). For example, the gate electrode 150 may overlap the second portion 320 of the first conductivity type doping pattern 300 to be described later in the third direction (Z direction), and may not overlap the first portion 310 and the third portion 330 of the first conductivity type doping pattern 300 in the third direction (Z direction), but example embodiments are not limited thereto.

The gate electrode 150 may include a conductive material. For example, the gate electrode 150 may include polysilicon doped with impurities. As another example, the gate electrode 150 may include a metal, a metal alloy, a conductive metal nitride, a metal silicide, a doped semiconductor material, a conductive metal oxide, a conductive metal nitride, or a combination thereof. The gate electrode 150 may be formed of a single layer or multiple layers.

The gate insulating layer 151 may be positioned between the first conductivity type semiconductor layer 131 and the gate electrode 150. That is, the gate insulating layer 151 may be positioned under the gate electrode 150 and may cover the lower surface of the gate electrode 150. In example embodiments, side surfaces of the gate insulating layer 151 and the gate electrode 150 may be aligned in the third direction (Z direction). The gate electrode 150 may be insulated from the first conductivity type semiconductor layer 131 by a gate insulating layer 151. The thickness of the gate insulating layer 151 may be almost constant. For example, the gate insulating layer 151 may have a uniform thickness in the third direction (Z direction). In an embodiment, the gate insulating layer 151 may overlap the second conductivity type doped well region 133 and the first conductivity type doping pattern 300 to be described later in the third direction (Z direction). The lower surface of the gate insulating layer 151 may be in direct contact with the second conductivity type doped well region 133 and the first conductivity type doping pattern 300 to be described later, but example embodiments are not limited thereto. The upper surface of the gate insulating layer 151 may be in direct contact with a lower surface of the gate electrode 150.

The gate insulating layer 151 may include an insulating material. For example, the gate insulating layer 151 may include SiO₂. However, other materials may also be used, and the material of the gate insulating layer 151 may be changed in various ways. As another example, the gate insulating layer 151 may include SiN, SiON, SiC, SiCN, or a combination thereof. The gate insulating layer 151 may be formed of a single layer or multiple layers.

The first conductivity type doping pattern 300 may be positioned within the second conductivity type doped well region 133. The first conductivity type doping pattern 300 may be positioned in the upper portion of the first conductivity type semiconductor layer 131. At least a portion of the first conductivity type doping pattern 300 may be surrounded by a second conductivity type doped well region 133. For example, the second conductivity type doped well region 133 may be positioned on opposite sides of at least a portion of the first conductivity type doping pattern 300 in the first direction (X direction). At least a portion of the first conductivity type doping pattern 300 may overlap at least a portion of the gate electrode 150 and at least a portion of the gate insulating layer 151 in the third direction (Z direction). Additionally, at least a portion of the first conductivity type doping pattern 300 may overlap at least a portion of the source electrode 173 to be described later in the third direction (Z direction). For example, at least a portion of the first conductivity type doping pattern 300 may overlap the contact portion 173C of the source electrode 173 to be described later in the third direction (Z direction). The upper surface of the first conductivity type doping pattern 300 may be in contact with the gate insulating layer 151 and the silicide layer 190 to be described later.

In an embodiment, the first conductivity type doping pattern 300 may extend in a third direction (Z direction) from the upper surface of the first conductivity type semiconductor layer 131. The first conductivity type doping pattern 300 may be embedded within the second conductivity type doped well region 133. In this case, the thickness of the first conductivity type doping pattern 300 in the third direction (Z direction) may be less than the thickness of the second conductivity type doped well region 133 in the third direction (Z direction). Accordingly, the lower surface and side surface of the first conductivity type doping pattern 300 may be surrounded by the second conductivity type doped well region 133.

In an embodiment, at least a portion of the gate electrode 150 may overlap the first conductivity type doping pattern 300 in the third direction (Z direction). For example, a part of the gate electrode 150 may overlap the first conductivity type doping pattern 300 in the third direction (Z direction), and the remaining part may overlap the second conductivity type doped well region 133 in the third direction (Z direction). Accordingly, the overlapping area between the gate electrode 150 and the first conductivity type doping pattern 300 may decrease, and the resistance value between the gate electrode 150 and the first conductivity type doping pattern 300 may increase.

According to an embodiment, the first conductivity type doping pattern 300 of the semiconductor device may be electrically connected to the source electrode 173. The first conductivity type doping pattern 300 may provide an electrical connection path between the source electrode 173 and the second conductivity type doped well region 133. For example, a first conductivity type doping pattern 300 of a semiconductor device according to an embodiment may include a first portion 310 overlapping a contact portion 173C of a source electrode 173 to be described later in a third direction (Z direction), a second portion 320 positioned adjacent to a gate electrode 150, and a third portion 330 connecting the first portion 310 and the second portion 320. When a turn-on signal is applied to the gate electrode 150, the driving current may flow sequentially from the source electrode 173 through the first portion 310, the second portion 320, and the third portion 330 to the second conductivity type doped well region 133. In this case, the first portion 310, the second portion 320, and the third portion 330 of the first conductivity type doping pattern 300 may have a predetermined resistance component, and the first conductivity type doping pattern 300 may function as a resistance element. For example, the first conductivity type doping pattern 300 may function as a ballast resistor. Accordingly, the first conductivity type doping pattern 300 may be patterned to have a predetermined resistance value. A detailed explanation of this will be provided later with further reference to FIG. 5.

In an embodiment, in order for the first conductivity type doping pattern 300 to function as a resistance element electrically connected between the contact portion 173C of the source electrode 173 to be described later and the second conductivity type doped well region 133, the first conductivity type doping pattern 300 may include at least one bent portion in a plan view. In an embodiment, the extended length DD of the first conductivity type doping pattern 300 may be greater than the length of the contact portion 173C in the second direction (Y direction). In an embodiment, the width of at least a portion of the first conductivity type doping pattern 300 may be less than the length of the contact portion 173C in the second direction (Y direction) to be described later. In an embodiment, the width of at least a portion of the first conductivity type doping pattern 300 may be less than the distance in the second direction (Y direction) between the contact portion 173C and the gate electrode 150. A detailed explanation of this will be provided later with further reference to FIG. 5.

The first conductivity type doping pattern 300 may be a doping region formed using an ion implantation process within the first conductivity type semiconductor layer 131. The first conductivity type doping pattern 300 may be formed of or include SiC. For example, the first conductivity type doping pattern 300 may include 4H SiC. The first conductivity type doping pattern 300 may be doped with an n-type impurity. The first conductivity type doping pattern 300 may be highly doped with an n-type impurity. The doping concentration of the first conductivity type doping pattern 300 may be about 1*10¹⁸cm⁻³ or more and about 5*10²⁰cm⁻³ or less. The material, doping type, doping concentration, etc. of the first conductivity type doping pattern 300 are not limited thereto and may be changed in various ways.

A semiconductor device according to an embodiment may further include a second conductivity type doped layer 135 positioned within a second conductivity type doped well region 133.

The second conductivity type doped layer 135 may be positioned within the second conductivity type doped well region 133. The second conductivity type doped layer 135 is positioned on top of the first conductivity type semiconductor layer 131 and may have an upper surface that is in contact with the lower surface of the silicide layer 190 connected to the source electrode 173 to be described later. In an embodiment, at least a portion of the upper surface of the second conductivity type doped layer 135 may be in contact with the lower surface of the silicide layer 190 to be described later, but example embodiments are not limited thereto. As another example, at least a portion of the upper surface of the second conductivity type doped layer 135 may be in contact with the lower surface of the source electrode 173. The second conductivity type doped layer 135 may be buried within the second conductivity type doped well region 133.

In an embodiment, the second conductivity type doped layer 135 may extend in a third direction (Z direction) from the upper surface of the first conductivity type semiconductor layer 131. In this case, the thickness of the second conductivity type doped layer 135 in the third direction (Z direction) may be less than the thickness of the second conductivity type doped well region 133 in the third direction (Z direction). In an embodiment, the thickness of the second conductivity type doped layer 135 in the third direction (Z direction) may be greater than or equal to the thickness of the first conductivity type doping pattern 300 in the third direction (Z direction), but example embodiments are not limited thereto. The second conductivity type doped layer 135 may be formed in at least a portion of the second conductivity type doped well region 133 through ion implantation.

The second conductivity type doped layer 135 may be formed of or include SiC. For example, the second conductivity type doped layer 135 may include 4H SiC. The second conductivity type doped layer 135 may be doped with a p-type impurity. The second conductivity type doped layer 135 may form an ohmic contact with the source electrode 173. For this purpose, the second conductivity type doped layer 135 may be doped at a high concentration with a p-type impurity. In an embodiment, the doping concentration of the second conductivity type doped layer 135 may be higher than the doping concentration of the second conductivity type doped well region 133. The doping concentration of the second conductivity type doped layer 135 may be about 1*10¹⁸cm⁻³ or more and about 5*10²⁰cm⁻³ or less. The material, doping type, doping concentration, etc. of the second conductivity type doped layer 135 are not limited thereto and may be changed in various ways.

A semiconductor device according to an embodiment may further include an interlayer insulating layer 140 positioned on a gate electrode 150.

The interlayer insulating layer 140 may be positioned on the first conductivity type semiconductor layer 131. The interlayer insulating layer 140 may be positioned on the gate electrode 150. Specifically, the interlayer insulating layer 140 may cover the upper surface and side surface of the gate electrode 150. The interlayer insulating layer 140 may cover the side surface of the gate insulating layer 151. For example, the interlayer insulating layer 140 may contact the upper and side surfaces of the gate electrode 150 and the side surface of the gate insulating layer 151. In an embodiment, the interlayer insulating layer 140 may also be positioned on at least a portion of the first conductivity type doping pattern 300 and at least a portion of the second conductivity type doped well region 133. The interlayer insulating layer 140 may have a lower surface that is in contact with at least a portion of the upper surface of the first conductivity type doping pattern 300 and the upper surface of the second conductivity type doped well region 133. The gate electrode 150 may be insulated from the source electrode 173 by an interlayer insulating layer 140.

The interlayer insulating layer 140 may include an insulating material. In an embodiment, the interlayer insulating layer 140 may include the same insulating material as the gate insulating layer 151. For example, the interlayer insulating layer 140 may include SiO₂. But example embodiments are not limited thereto, and the interlayer insulating layer 140 may include various types of insulating materials to insulate the gate electrode 150 from the source electrode 173. For example, the interlayer insulating layer 140 may include SiOP, SiN, SiON, or a combination thereof. The interlayer insulating layer 140 may be composed of a single layer or multiple layers. When the interlayer insulating layer 140 is made of the same material as the gate insulating layer 151, the boundary between the interlayer insulating layer 140 and the gate insulating layer 151 may not be clearly distinguished at the part where the interlayer insulating layer 140 and the gate insulating layer 151 come into contact.

The source electrode 173 may be positioned on the second conductivity type doped well region 133. A second conductivity type doped layer 135 and a first conductivity type doping pattern 300 may be positioned between the source electrode 173 and the second conductivity type doped well region 133. The source electrode 173 may be electrically connected to the second conductivity type doped well region 133 through the second conductivity type doped layer 135. The source electrode 173 may be electrically connected to the first conductivity type doping pattern 300.

According to an embodiment, a source electrode 173 of a semiconductor device may include a contact portion 173C positioned between a plurality of gate electrodes 150 spaced apart from each other in a first direction (X direction).

The contact portion 173C may be positioned between a plurality of gate electrodes 150 spaced apart in the first direction (X direction). The contact portion 173C may refer to a portion of a source electrode 173 positioned between a plurality of gate electrodes 150 spaced apart in the first direction (X direction). The contact portion 173C may extend lengthwise in the second direction (Y direction). The contact portion 173C may extend in a direction parallel to the gate electrode 150. The contact portion 173C may be positioned on the side surface of the gate electrode 150. An interlayer insulating layer 140 may be positioned between the contact portion 173C and the gate electrode 150. The contact portion 173C may be separated from the gate electrode 150 by an interlayer insulating layer 140. The contact portion 173C may contact the side surface of the interlayer insulating layer 140.

The contact portion 173C may overlap the second conductivity type doped well region 133 and the first conductivity type doping pattern 300 in the third direction (Z direction). For example, the contact portion 173C may overlap a portion of the second conductivity type doped well region 133 in the third direction (Z direction). In addition, the contact portion 173C may overlap the first portion 310 of the first conductivity type doping pattern 300 in the third direction (Z direction) and may not overlap the second portion 320 and the third portion 330 in the third direction (Z direction). But example embodiments are not limited thereto, and as another example, the contact portion 173C may not overlap the first conductivity type doping pattern 300 in the third direction (Z direction). In this case, the upper surface of the first conductivity type doping pattern 300 may be covered by a gate insulating layer 151. The contact portion 173C may overlap the second conductivity type doped layer 135 in the third direction (Z direction).

In an embodiment, at least a portion of the contact portion 173C may overlap the first conductivity type doping pattern 300 in the third direction (Z direction). For example, a part of the contact portion 173C may overlap the first conductivity type doping pattern 300 in the third direction (Z direction), and the remaining part may overlap the second conductivity type doped well region 133 in the third direction (Z direction). Accordingly, the overlapping area between the contact portion 173C and the first conductivity type doping pattern 300 may decrease, and the resistance value between the contact portion 173C and the first conductivity type doping pattern 300 may increase.

The source electrode 173 may include a conductive material. For example, the source electrode 173 may include a metal, a metal alloy, a conductive metal nitride, a metal silicide, a doped semiconductor material, a conductive metal oxide, or a conductive metal nitride. For example, the source electrode 173 may be formed of titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAIN), tungsten nitride (WN), ruthenium (Ru), titanium aluminum (TiAl), titanium aluminum carbide nitride (TiAlC-N), titanium aluminum carbide (TiAlC), titanium carbide (TiC), tantalum carbide nitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo). It may include, but is not limited to, molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or combinations thereof. The source electrode 173 may be formed of a single layer or multiple layers.

A semiconductor device according to an embodiment may further include a silicide layer 190 positioned between the source electrode 173 and the second conductivity type doped layer 135 and between the source electrode 173 and the first conductivity type doping pattern 300.

The silicide layer 190 may be conformally positioned along the interface between the source electrode 173 and the second conductivity type doped layer 135 and between the source electrode 173 and the first conductivity type doping pattern 300. The silicide layer 190 may be positioned between the contact portion 173C of the source electrode 173 and the second conductivity type doped well region 133. The silicide layer 190 may be positioned between the contact portion 173C and the first conductivity type doping pattern 300 and between the contact portion 173C and the second conductivity type doped layer 135. The lower surface of the silicide layer 190 may be in contact with the second conductivity type doped layer 135 and the first conductivity type doping pattern 300. In an embodiment, the lower surface of the silicide layer 190 may be in contact with the second conductivity type doped well region 133. The upper surface of the silicide layer 190 may be in contact with the source electrode 173.

The silicide layer 190 may include a metal silicide material. For example, the silicide layer 190 may include tungsten silicide (WSi), titanium silicide (TiSi), cobalt silicide (CoSi), nickel silicide (NiSi), or a combination thereof. In a manufacturing process of a semiconductor device according to an embodiment, a silicidation process may be performed on an upper surface of a second conductivity type doped layer 135 and a first conductivity type doping pattern 300 exposed by a trench between adjacent gate electrodes 150 in a first direction (X direction) to form a silicide layer 190. But example embodiments are not limited thereto, and after forming the source electrode 173, an annealing process may be performed subsequently to reduce the contact resistance between the second conductivity type doped layer 135 and the contact portion 173C and between the first conductivity type doping pattern 300 and the contact portion 173C. Accordingly, the silicide layer 190 may be formed along the interface between the contact portion 173C and the second conductivity type doped layer 135, and between the contact portion 173C and the first conductivity type doping pattern 300.

The drain electrode 175 may be positioned on the second surface, e.g., the lower surface, of the substrate 110. The upper surface of the drain electrode 175 may be in contact with the lower surface of the substrate 110. The drain electrode 175 may be in ohmic contact with the substrate 110. The region in contact with the drain electrode 175 within the substrate 110 may be doped at a relatively high concentration compared to other regions. But example embodiments are not limited thereto, and another layer may be additionally positioned between the drain electrode 175 and the substrate 110. For example, a silicide layer may be positioned between the drain electrode 175 and the substrate 110. The silicide layer may include a metal silicide material. The metal silicide layer may facilitate electrical connection between the drain electrode 175 and the substrate 110.

The drain electrode 175 may include a conductive material. For example, the drain electrode 175 may include a metal, a metal alloy, a conductive metal nitride, a metal silicide, a doped semiconductor material, a conductive metal oxide, or a conductive metal nitride. The drain electrode 175 may be made of the same material as the source electrode 173 or may be made of a different material. The drain electrode 175 may be formed of a single layer or multiple layers.

According to an embodiment, a semiconductor device may cause a driving current to flow in a third direction (Z direction) from the drain electrode 175 toward the source electrode 173 when a turn-on signal is applied to the gate electrode 150. In this case, the driving current may flow from the drain electrode 175 to the source electrode 173, through the substrate 110, the first conductivity type semiconductor layer 131, a portion of the second conductivity type doped well region 133 adjacent to the gate electrode 150, and the first conductivity type doping pattern 300.

Hereinafter, with further reference to FIG. 5, the first conductivity type doping pattern 300 of a semiconductor device according to an embodiment will be described in detail.

FIG. 5 is a plan view showing the arrangement of a first conductivity type doping pattern of a semiconductor device according to an example embodiment. For clarity, in FIG. 5, a first conductivity type doping pattern 300, a second conductivity type doped well region 133, a second conductivity type doped layer 135, a contact portion 173C, and a gate electrode 150 are illustrated, and the illustration of the remaining components is omitted.

Referring further to FIG. 5, the first conductivity type doping pattern 300 of the semiconductor device according to an embodiment may provide an electrical connection path between the contact portion 173C and the second conductivity type doped well region 133. In this case, the first conductivity type doping pattern 300 may have a predetermined resistance component and may function as a resistance element. For example, the first conductivity type doping pattern 300 may function as a ballast resistor.

The first conductivity type doping pattern 300 of a semiconductor device according to an embodiment may include a first portion 310 overlapping a contact portion 173C in a third direction (Z direction), a second portion 320 positioned adjacent to a gate electrode 150, and a third portion 330 connecting the first portion 310 and the second portion 320.

The first portion 310 may extend in the first direction (X direction). The first portion 310 may overlap the contact portion 173C in the third direction (Z direction). The first portion 310 may refer to the first conductivity type doping pattern 300 that extends in the first direction (X direction) and overlaps the contact portion 173C in the third direction (Z direction). The first portion 310 does not overlap the gate electrode 150 in the third direction (Z direction). As illustrated in FIG. 2, at least a portion of the first portion 310 may overlap the interlayer insulating layer 140 in the third direction (Z direction), but example embodiments are not limited thereto. In an embodiment, the first width W1 of the first portion 310 in the second direction (Y direction) may be less than the first length D1 of the contact portion 173C in the second direction (Y direction), but example embodiments are not limited thereto. Accordingly, the resistance value of the first portion 310 may increase. Additionally, the length of the first portion 310 in the first direction (X direction) may be less than the length in the first direction (X direction) between the contact portion 173C and the gate electrode 150, but example embodiments are not limited thereto.

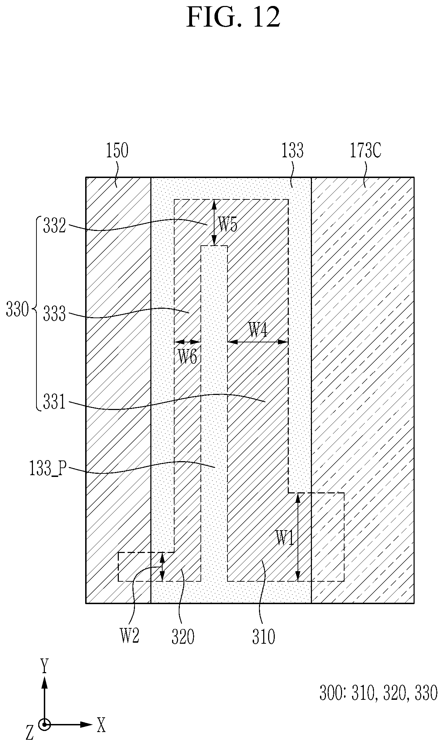

The second portion 320 may extend in the first direction (X direction). The second portion 320 may extend in a direction parallel to the first portion 310, but example embodiments are not limited thereto. The second portion 320 may overlap the gate electrode 150 in the third direction (Z direction), but example embodiments are not limited thereto. In an embodiment, the second portion 320 may mean a portion of the first conductivity type doping pattern 300 that extends in the first direction (X direction) and overlaps the gate electrode 150 in the third direction (Z direction). The second portion 320 does not overlap the contact portion 173C in the third direction (Z direction). As illustrated in FIG. 3, at least a portion of the second portion 320 may overlap the interlayer insulating layer 140 in the third direction (Z direction), but example embodiments are not limited thereto. In an embodiment, the second width W2 of the second portion 320 in the second direction (Y direction) may be less than the second length D2 of the gate electrode 150 in the second direction (Y direction), but example embodiments are not limited thereto. Accordingly, the resistance value of the second portion 320 may increase. The second width W2 of the second portion 320 in the second direction (Y direction) may be substantially the same as the first width W1 of the first portion 310 in the second direction (Y direction), but example embodiments are not limited thereto. An explanation of this will be provided later with reference to FIG. 12. Additionally, the length of the second portion 320 in the first direction (X direction) may be less than the length in the first direction (X direction) between the contact portion 173C and the gate electrode 150, but example embodiments are not limited thereto.

The third portion 330 may be positioned between the first portion 310 and the second portion 320. The third portion 330 may extend in the second direction (Y direction) to connect the first portion 310 and the second portion 320. The third portion 330 does not overlap the source electrode 173 and the gate electrode 150 in the third direction (Z direction). In an embodiment, the third portion 330 may mean a portion of the first conductivity type doping pattern 300 that connects the first portion 310 and the second portion 320 and does not overlap the source electrode 173 and the gate electrode 150 in the third direction (Z direction). The third portion 330 may extend in a direction parallel to the gate electrode 150, but example embodiments are not limited thereto. The third portion 330 may extend in a direction parallel to the contact portion 173C, but example embodiments are not limited thereto. As illustrated in FIG. 4, the third portion 330 may overlap the interlayer insulating layer 140 in the third direction (Z direction), but example embodiments are not limited thereto. The third width W3 of the third portion 330 in the first direction (X direction) may be less than the length between the contact portion 173C and the gate electrode 150 in the first direction (X direction). In this case, the resistance value of the third portion 330 may increase.

In an embodiment, from the first portion 310 to the third portion 330 may have predetermined resistance values. Accordingly, the first conductivity type doping pattern 300 may function as a resistance element having a predetermined resistance value. That is, the first conductivity type doping pattern 300 may function as a resistance element that electrically connects the contact portion 173C of the source electrode 173 and the second conductivity type doped well region 133.

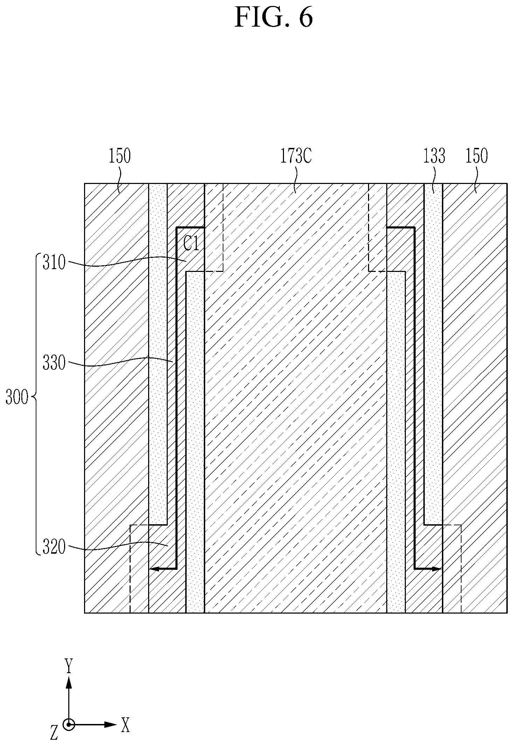

In an embodiment, the first conductivity type doping pattern 300 may have various shapes to achieve a predetermined resistance value. For example, the first width W1 of the first portion 310 in the second direction (Y direction) may be less than the first length D1 of the contact portion 173C in the second direction (Y direction), or the second width W2 of the second portion 320 in the second direction (Y direction) may be less than the second length D2 of the gate electrode 150 in the second direction (Y direction), or the third width W3 of the third portion 330 in the first direction (X direction) may be less than the length between the contact portion 173C and the gate electrode 150 in the first direction (X direction). In this case, current may flow sequentially from the contact portion 173C through the first portion 310, the third portion 330, and the second portion 320 to the second conductivity type doped well region 133, thereby reducing the driving current (see C1 of FIG. 6) of the semiconductor device according to an embodiment.

In an embodiment, the first conductivity type doping pattern 300 may include at least one bent portion in the plan view. For example, the first conductivity type doping pattern 300 may include a bent portion positioned between the first portion 310 and the third portion 330 and between the second portion 320 and the third portion 330. The bent portion may be located at a point where the first portion 310 and the third portion 330 meet and at a point where the second portion 320 and the third portion 330 meet. As the first conductivity type doping pattern 300 of the semiconductor device according to an embodiment includes at least one bent portion, the extended length of the first conductivity type doping pattern 300 may increase, and the resistance value of the first conductivity type doping pattern 300 may increase, thereby reducing the driving current (see C1 of FIG. 6) of the semiconductor device according to an embodiment.

In an embodiment, the extended length DD of the first conductivity type doping pattern 300 may be greater than the first length D1 in the second direction (Y direction) of the contact portion 173C. For example, the sum of the length of the first portion 310 in the first direction (X direction), the length of the second portion 320 in the first direction (X direction), and the length of the third portion 330 in the second direction (Y direction) may be greater than the first length D1 of the contact portion 173C in the second direction (Y direction). Here, the extended length DD of the first conductivity type doping pattern 300 may mean the sum of the lengths in the extension direction of each of the first portion 310 to the third portion 330 of the first conductivity type doping pattern 300. For example, the extended length DD of the first conductivity type doping pattern 300 may be a sum of the length of the first portion 310 in the first direction (X direction), the length of the second portion 320 in the first direction (X direction), and the length of the third portion 330 in the second direction (Y direction). Additionally, the sum of the length of the first portion 310 in the first direction (X direction), the length of the second portion 320 in the first direction (X direction), and the length of the third portion 330 in the second direction (Y direction) may be greater than the second length D2 of the gate electrode 150 in the second direction (Y direction). In this case, the resistance value of the first conductivity type doping pattern 300 increases, thereby reducing the driving current (see C1 of FIG. 6) of the semiconductor device according to an embodiment.

In FIGS. 1 to 5, the first conductivity type doping pattern 300 is described as including portions extending in the first direction (X direction) and/or the second direction (Y direction), but example embodiments are not limited thereto, and the shape of the first conductivity type doping pattern 300 may be changed in various ways.

According to an embodiment, a second conductivity type doped well region 133 of a semiconductor device may include a patterned portion 133PP positioned between the second conductivity type doped layer 135 and the third portion 330.

As illustrated in FIGS. 3 to 5, the patterned portion 133PP may be positioned between the second conductivity type doped layer 135 and the first conductivity type doping pattern 300. For example, the patterned portion 133PP may be positioned between the second conductivity type doped layer 135 and the third portion 330, but example embodiments are not limited thereto. The patterned portion 133PP may refer to the second conductivity type doped well region 133 positioned between the second conductivity type doped layer 135 and the third portion 330. The patterned portion 133PP may extend in the second direction (Y direction). The patterned portion 133PP may extend parallel to the third portion 330. At least a portion of the first conductivity type doping pattern 300 may be defined by the patterned portion 133PP. The upper surface of the patterned portion 133PP may be in contact with the first portion 310, and one side of the patterned portion 133PP may be in contact with the third portion 330. In an embodiment, the patterned portion 133PP may be positioned on one side of the third portion 330 in the first direction (X direction), but example embodiments are not limited thereto. Accordingly, the second conductivity type doped well region 133 may be positioned on opposite sides of the third portion 330 in the first direction (X direction).

In an embodiment, the length of the patterned portion 133PP in the second direction (Y direction) may be less than the first length D1 of the contact portion 173C in the second direction (Y direction). In this case, a portion of the contact portion 173C and the first conductivity type doping pattern 300 may overlap in the third direction (Z direction).

In an embodiment, the patterned portion 133PP may overlap a portion of the contact portion 173C in the third direction (Z direction). For example, a part of the contact portion 173C may overlap the first conductivity type doping pattern 300 in the third direction (Z direction), and the remaining part of the contact portion 173C may overlap the patterned portion 133PP in the third direction (Z direction). The upper surface of the patterned portion 133PP may be in contact with the silicide layer 190.

Hereinafter, the effect of a semiconductor device according to an embodiment will be described with further reference to FIG. 6.

FIG. 6 is a plan view showing the flow of driving current of a semiconductor device according to an example embodiment.

Referring further to FIG. 6, the source electrode 173, the drain electrode 175, and the gate electrode 150 of the semiconductor device according to an embodiment may constitute a transistor. In this case, a part of the second conductivity type doped well region 133 may function as a channel of the transistor. According to an embodiment, when a turn-on signal is applied to the gate electrode 150, a semiconductor device may allow a driving current C1 to flow sequentially from the contact portion 173C of the source electrode 173 through the first portion 310, the third portion 330, and the second portion 320 to the second conductivity type doped well region 133.

According to an embodiment, the first conductivity type doping pattern 300 of the semiconductor device may have various shapes so as to have a predetermined resistance value. For example, the first width W1 of the first portion 310 in the second direction (Y direction) may be less than the first length D1 of the contact portion 173C in the second direction (Y direction), or the second width W2 of the second portion 320 in the second direction (Y direction) may be less than the second length D2 of the gate electrode 150 in the second direction (Y direction), or the third width W3 of the third portion 330 in the first direction (X direction) may be less than the length between the contact portion 173C and the gate electrode 150 in the first direction (X direction). As another example, the first conductivity type doping pattern 300 may include at least one bent portion in a plan view. As another example, the extended length DD of the first conductivity type doping pattern 300 may be greater than the first length D1 in the second direction (Y direction) of the contact portion 173C. Accordingly, within a range where the distance between the gate electrode 150 and the contact portion 173C is not changed, the resistance value of the first conductivity type doping pattern 300 may increase, and the size of the driving current C1 flowing through the first conductivity type doping pattern 300 may decrease. Accordingly, the reliability of a semiconductor device according to an embodiment may be improved by reducing the size of the driving current C1 within a range without changing the size of the transistor device.

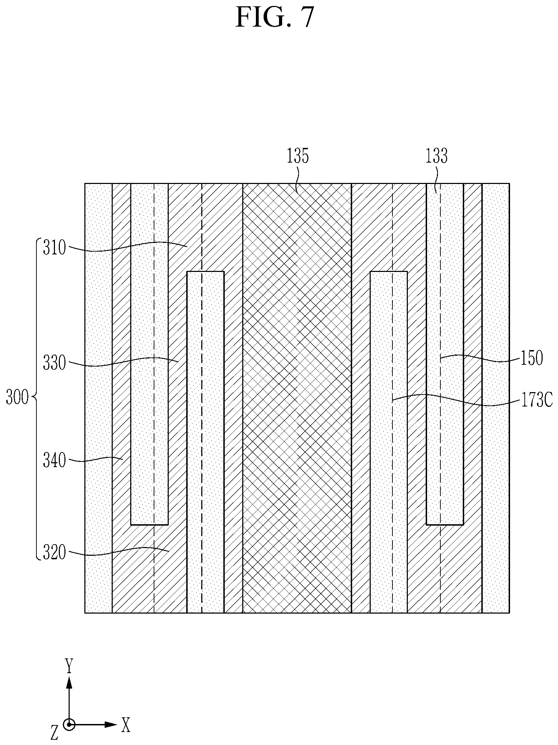

Hereinafter, barrier patterns of semiconductor devices according to some embodiments will be described with reference to FIGS. 7 to 14.

FIG. 7 is a plan view showing the arrangement of a first conductivity type doping pattern of a semiconductor device according to some embodiments.

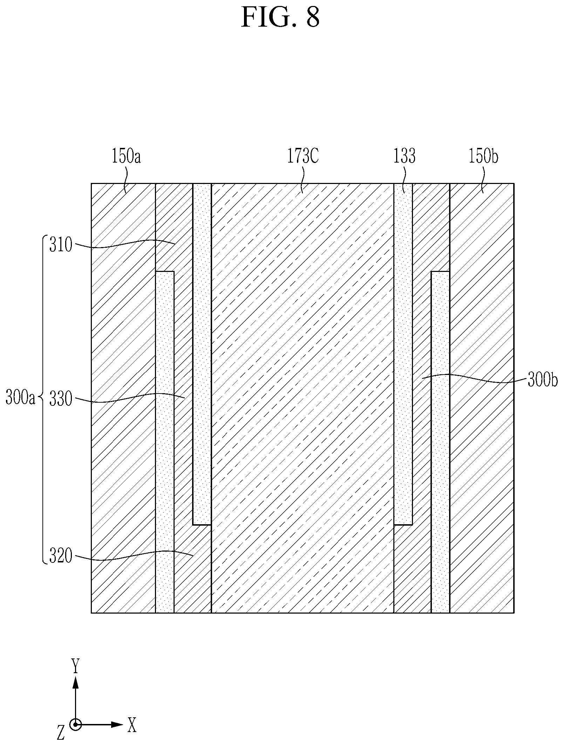

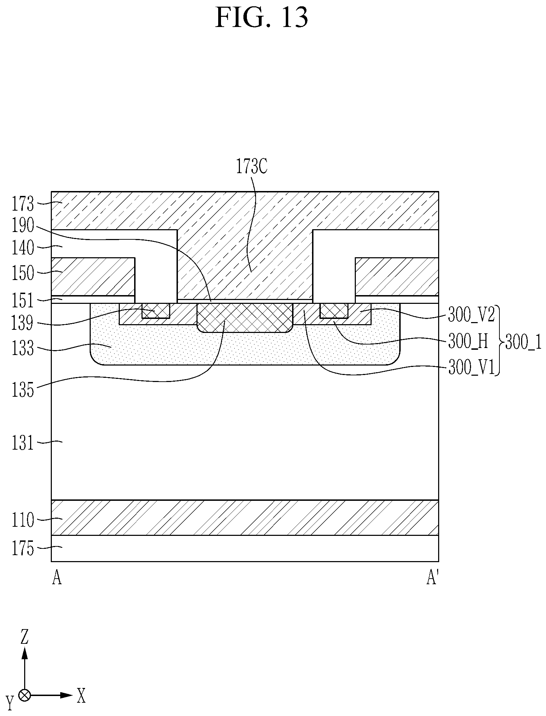

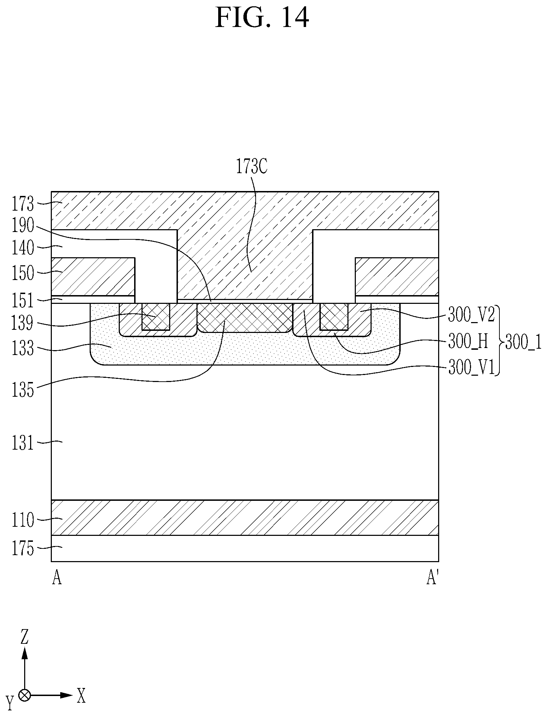

FIGS. 8 to 12 are plan views illustrating semiconductor devices according to some embodiments. FIGS. 13 and 14 are cross-sectional views illustrating semiconductor devices according to some embodiments.

FIGS. 7 to 14 illustrate various modified examples of semiconductor devices according to an embodiment illustrated in FIGS. 1 to 6. The embodiments illustrated in FIGS. 7 to 14 are substantially the same as the embodiments illustrated in FIGS. 1 to 6, so descriptions thereof will not be repeated and the differences will be mainly explained. Additionally, the same drawing symbols are used for the same components as in the previous embodiment.

Referring to FIG. 7, the first conductivity type doping pattern 300 of the semiconductor device according to some embodiments may further include a fourth portion 340 connected to the second portion 320.

In some embodiments, the fourth portion 340 may extend lengthwise in the second direction (Y direction). The fourth portion 340 may extend parallel to the gate electrode 150. The fourth portion 340 may extend parallel to the third portion 330, but example embodiments are not limited thereto. The fourth portion 340 may overlap the gate electrode 150 in the third direction (Z direction) and may not overlap the contact portion 173C in the third direction (Z direction). The fourth portion 340 may completely overlap the gate electrode 150 in the third direction (Z direction), but example embodiments are not limited thereto. At least a portion of the fourth portion 340 may be surrounded by a second conductivity type doped well region 133.

In some embodiments, a second conductivity type doped well region 133 may be positioned between the fourth portion 340 and the second portion 320. The fourth portion 340 may be defined by the second conductivity type doped well region 133. Opposite sides of the fourth portion 340 in the first direction (X direction) may be in contact with the second conductivity type doped well region 133, but are not limited thereto.

Referring to FIG. 8, the first conductivity type doping pattern 300 of the semiconductor device according to some embodiments may have various shapes. For example, a semiconductor device according to some embodiments may include a first gate electrode 150a and a second gate electrode 150b positioned on opposite sides of a contact portion 173C. Additionally, the semiconductor device according to some embodiments may include a first doping pattern 300a positioned between the contact portion 173C and the first gate electrode 150a and a second doping pattern 300b positioned between the contact portion 173C and the second gate electrode 150b. The first doping pattern 300a and the second doping pattern 300b may have substantially the same configuration as the first conductivity type doping pattern 300 of the embodiments of FIGS. 1 to 6.

In some embodiments, the first doping pattern 300a and the second doping pattern 300b may have an asymmetrical shape. For example, the first doping pattern 300a may be asymmetrical with respect to the second doping pattern 300b and the reference axis extending in the second direction (Y direction). The first doping pattern 300a and the second doping pattern 300b have the same shape and may be arranged spaced apart from each other in the first direction (X direction). In some embodiments, at least one of the first doping pattern 300a and the second doping pattern 300b may have the same shape as the first conductivity type doping pattern 300 of the embodiments of FIGS. 1 to 6.

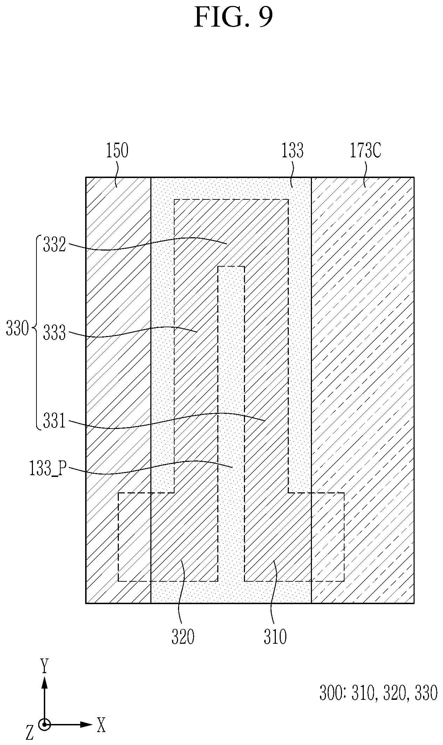

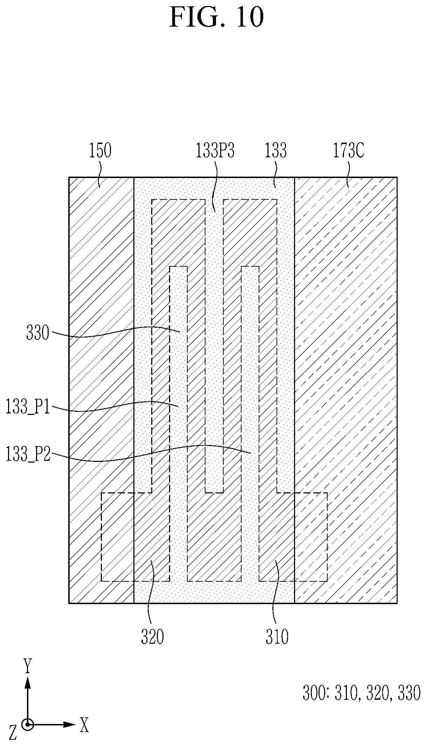

Referring to FIGS. 9 and 10, the first conductivity type doping pattern 300 of the semiconductor device according to some embodiments may have various shapes. In some embodiments, the third portion 330 of the first conductivity type doping pattern 300 may include a plurality of extension portions 331, 332, 333 extending in different directions.

For example, as illustrated in FIG. 9, the third portion 330 may include a first extension portion 331 connected to the first portion 310 and extending in a second direction (Y direction), a second extension portion 332 connected to the first extension portion 331 and extending in the first direction (X direction), and a third extension portion 333 connecting the second extension portion 332 and the second portion 320 and extending in the second direction (Y direction).

The first extension portion 331 and the third extension portion 333 may extend in a parallel direction, and the second extension portion 332 may extend in a parallel direction with the first portion 310 and the second portion 320, but example embodiments are not limited thereto. In some embodiments, the lengths of the first extension portion 331 and the third extension portion 333 in the second direction (Y direction) may be less than or equal to the length of the contact portion 173C in the second direction (Y direction), but are not limited thereto. In some embodiments, the length of the second extension portion 332 in the first direction (X direction) may be less than the length in the first direction (X direction) between the gate electrode 150 and the contact portion 173C, but example embodiments are not limited thereto.

In some embodiments, the first extension portion 331 to the third extension portion 333 may be defined by the second conductivity type doped well region 133. For example, the second conductivity type doped well region 133 may further include a protrusion portion 133_P positioned between the first extension portion 331 and the third extension portion 333. The protrusion portion 133_P may be positioned between the first extension portion 331 and the third extension portion 333. One side of the protrusion portion 133_P may be in contact with the first extension portion 331, the other side may be in contact with the third extension portion 333, and the upper surface of the protrusion portion 133_P may be in contact with the second extension portion 332. The length of the protrusion portion 133_P in the second direction (Y direction) may be less than the length of the contact portion 173C in the second direction (Y direction).

In some embodiments, since the third portion 330 includes a plurality of extension portions 331, 332, 333, the extended length of the first conductivity type doping pattern 300 may be further increased, and the resistance value of the first conductivity type doping pattern 300 may be further increased, thereby reducing the driving current (see C1 of FIG. 6) of the semiconductor device according to some embodiments. Accordingly, the reliability of semiconductor devices may be improved.

In FIG. 9, the third portion 330 is illustrated as including three extension portions 331, 332, 333, but example embodiments are not limited thereto. As another example, as illustrated in FIG. 10, the third portion 330 of the semiconductor device according to some embodiments may include four extensions extending in the second direction (Y direction) and a portion extending in the first direction (X direction) to connect between the extensions. In some embodiments, the second conductivity type doped well region 133 may include a plurality of protrusion portions 133_P1, 133_P2 positioned between extensions extending in the second direction (Y direction). As another example, the third portion 330 may extend in a direction different from the first direction (X direction) and the second direction (Y direction). As another example, the third portion 330 may have a shape having a predetermined curvature.

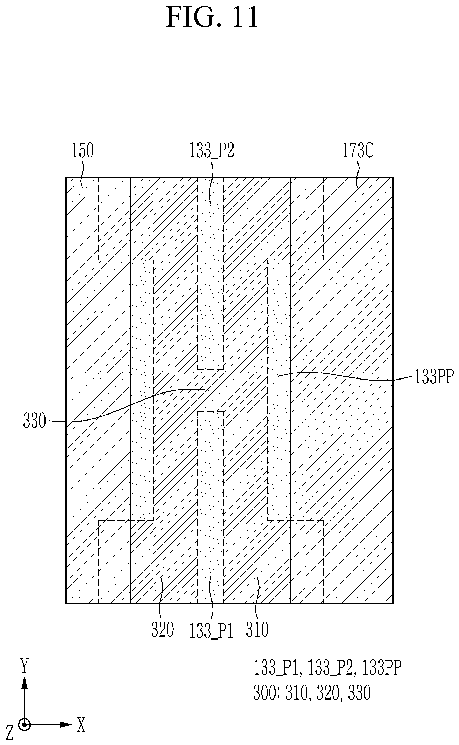

Referring to FIG. 11, a first conductivity type doping pattern 300 of a semiconductor device according to some embodiments may include a plurality of first portions 310 overlapping a contact portion 173C in a third direction (Z direction). In some embodiments, multiple first portions 310 may be provided to overlap the contact portion 173C in the third direction (Z direction). The plurality of first portions 310 may be defined by the second conductivity type doped well region 133. At least a portion of the plurality of first portions 310 may be surrounded by a second conductivity type doped well region 133. For example, the patterned portion 133PP of the second conductivity type doped well region 133 may be positioned between a plurality of first portions 310, and the plurality of first portions 310 may be spaced apart in the second direction (Y direction) by the patterned portion 133PP.

Additionally, the first conductivity type doping pattern 300 of the semiconductor device according to some embodiments may include a plurality of second portions 320 overlapping the gate electrode 150 in a third direction (Z direction). In some embodiments, the second portion 320 may be provided in multiples to overlap the gate electrode 150 in the third direction (Z direction). The plurality of second portions 320 may be defined by a second conductivity type doped well region 133. For example, at least a portion of the plurality of second portions 320 may be surrounded by a second conductivity type doped well region 133.

In some embodiments, the third portion 330 may connect between a plurality of first portions 310 and a plurality of second portions 320. In some embodiments, the first conductivity type doping pattern 300 may have an approximately 'H' shape in the plane, but example embodiments are not limited thereto.

Referring to FIG. 12, the first conductivity type doping pattern 300 of a semiconductor device according to some embodiments may include portions having different widths. For example, the first width W1 in the second direction (Y direction) of the first portion 310, the second width W2 in the second direction (Y direction) of the second portion 320, and the fifth width W5 in the second direction (Y direction) of the second extension portion 332 may be different. For example, the first width W1 of the first portion 310 in the second direction (Y direction) may be different from the second width W2 of the second portion 320 in the second direction (Y direction). The first width W1 of the first portion 310 in the second direction (Y direction) may be larger than the second width W2 of the second portion 320 in the second direction (Y direction), but example embodiments are not limited thereto. Additionally, the fourth width W4 of the first extension portion 331 in the first direction (X direction) and the sixth width W6 of the third extension portion 333 in the first direction (X direction) may be different. The fourth width W4 of the first extension portion 331 in the first direction (X direction) may be larger than the sixth width W6 of the third extension portion 333 in the first direction (X direction), but example embodiments are not limited thereto.

In some embodiments, the first width W1 of the first portion 310 in the second direction (Y direction), the fourth width W4 of the first extension portion 331 in the first direction (X direction), the fifth width W5 of the second extension portion 332 in the second direction (Y direction), the sixth width W6 of the third extension portion 333 in the first direction (X direction), and the second width W2 of the second portion 320 in the second direction (Y direction) may sequentially decrease. That is, the first width W1 of the first portion 310 in the second direction (Y direction) may be the largest, and the second width W2 of the second portion 320 in the second direction (Y direction) may be the smallest, but example embodiments are not limited thereto. In some embodiments, since the first conductivity type doping pattern 300 includes portions having different widths, the first conductivity type doping pattern 300 having a desired resistance value may be easily designed.

Referring to FIGS. 13 and 14, a semiconductor device according to some example embodiments may further include a dummy pattern 139 positioned within a first conductivity type doping pattern 300_1.

The dummy pattern 139 may be positioned in the upper portion of the first conductivity type semiconductor layer 131. An upper surface of the dummy pattern 139 may be coplanar with an upper surface of the first conductivity type doping pattern 300_1. The dummy pattern 139 may be surrounded by a first conductivity type doping pattern 300_1. For example, the first conductivity type doping pattern 300_1 may be positioned on the lower surface and side surface of the dummy pattern 139. Accordingly, the dummy pattern 139 may be positioned apart from the second conductivity type doped well region 133.

In some embodiments, the dummy pattern 139 may extend in a third direction (Z direction) from the upper surface of the first conductivity type semiconductor layer 131. The dummy pattern 139 may be embedded within the first conductivity type doping pattern 300_1. In this case, the thickness of the dummy pattern 139 in the third direction (Z direction) may be less than the thickness of the first conductivity type doping pattern 300_1 in the third direction (Z direction). Accordingly, the lower surface and side surface of the dummy pattern 139 may be surrounded by the first conductivity type doping pattern 300_1.

In some embodiments, as illustrated in FIG. 13, the thickness of the dummy pattern 139 in the third direction (Z direction) may be less than the thickness of the second conductivity type doped layer 135 in the third direction (Z direction). In this case, the thickness of the first conductivity type doping pattern 300_1 in the third direction (Z direction) may be less than the thickness of the second conductivity type doped layer 135 in the third direction (Z direction). But example embodiments are not limited thereto, and as illustrated in FIG. 14, the thickness of the dummy pattern 139 in the third direction (Z direction) may be substantially the same as the thickness of the second conductivity type doped layer 135 in the third direction (Z direction). In this case, the thickness of the first conductivity type doping pattern 300_1 in the third direction (Z direction) may be greater than the thickness of the second conductivity type doped layer 135 in the third direction (Z direction).

In some embodiments, the dummy pattern 139 may be a doped region formed using an ion implantation process within the dummy pattern 139. The dummy pattern 139 may include SiC. For example, the dummy pattern 139 may include 4H SiC. The dummy pattern 139 may have a second conductivity type. The dummy pattern 139 may be doped with a p-type impurity. The doping concentration of the dummy pattern 139 may be substantially the same as the doping concentration of the second conductivity type doped layer 135, but example embodiments are not limited thereto. As another example, the doping concentration of the dummy pattern 139 may be substantially the same as the doping concentration of the second conductivity type doped well region 133. The material, doping type, doping concentration, etc. of the dummy pattern 139 are not limited thereto and may be changed in various ways.

A first conductivity type doping pattern 300_1 of a semiconductor device according to some embodiments may include a first vertical portion 300_V1 electrically connected to a contact portion 173C, a second vertical portion 300_V2 positioned adjacent to a gate electrode 150, and a horizontal portion 300_H connecting the first vertical portion 300_V1 and the second vertical portion 300_V2.

In some embodiments, the first vertical portion 300_V1 may overlap the contact portion 173C in the third direction (Z direction) and may not overlap the gate electrode 150 in the third direction (Z direction). The first vertical portion 300_V1 may be positioned between the second conductivity type doped layer 135 and the dummy pattern 139. The first vertical portion 300_V1 may be in contact with the second conductivity type doped layer 135 and the dummy pattern 139, but example embodiments are not limited thereto.

In some embodiments, the second vertical portion 300_V2 may overlap the gate electrode 150 in the third direction (Z direction) and may not overlap the contact portion 173C in the third direction (Z direction). The second vertical portion 300_V2 may be positioned between the second conductivity type doped well region 133 and the dummy pattern 139. The second vertical portion 300_V2 may be in contact with the second conductivity type doped well region 133 and the dummy pattern 139, but example embodiments are not limited thereto. In some embodiments, a dummy pattern 139 may be positioned between the first vertical portion 300_V1 and the second vertical portion 300_V2. That is, the first vertical portion 300_V1 and the second vertical portion 300_V2 may be spaced apart in the first direction (X direction) by the dummy pattern 139.

The horizontal portion 300_H may be positioned between the first vertical portion 300_V1 and the second vertical portion 300_V2. The horizontal portion 300_H may connect the first vertical portion 300_V1 and the second vertical portion 300_V2. The horizontal portion 300_H may be positioned between the second conductivity type doped well region 133 and the dummy pattern 139. The horizontal portion 300_H may be positioned on the lower surface of the dummy pattern 139. The horizontal portion 300_H may contact the lower surface of the dummy pattern 139.

A semiconductor device according to some embodiments may include a dummy pattern 139 positioned within a first conductivity type doping pattern 300_1. Accordingly, a path of driving current may be formed from the contact portion 173C to the channel region of the second conductivity type doped well region 133 through the first vertical portion 300_V1, horizontal portion 300_H, and second vertical portion 300_V2 of the first conductivity type doping pattern 300_1 sequentially. Accordingly, within a range where the distance between the gate electrode 150 and the contact portion 173C is not changed, the resistance value of the first conductivity type doping pattern 300_1 may increase, and the size of the driving current flowing through the first conductivity type doping pattern 300_1 may decrease. Therefore, the reliability of the semiconductor device may be improved by reducing the size of the driving current C1 within a range that does not change the size of the transistor device.

Hereinafter, semiconductor devices according to some embodiments will be described with reference to FIGS. 15 to 17.

FIGS. 15 to 17 are cross-sectional views illustrating semiconductor devices according to some example embodiments.

FIGS. 15 to 17 illustrate various modified examples of semiconductor devices according to the embodiments illustrated in FIGS. 13 and 14. The embodiments illustrated in FIGS. 15 to 17 are substantially the same as the embodiments illustrated in FIGS. 13 and 14, so a repeated description thereof will be omitted and the differences will be mainly described. Additionally, the same drawing symbols are used for the same components as in the previous embodiment.

Referring to FIGS. 15 to 17, a first conductivity type semiconductor layer 131 of a semiconductor device according to some embodiments may include a gate trench 160.

In some embodiments, the gate trench 160 may be formed to have a predetermined depth in the upper surface of the first conductivity type semiconductor layer 131. As shown in FIGS. 15 to 17, the gate trench 160 may be formed in an approximately U-shape in cross section. The gate trench 160 may include a bottom surface and side walls extending from the bottom surface. In FIGS. 15 to 17, the angle of the side wall relative to the bottom surface of the gate trench 160 is depicted as being vertical (e.g., a right angle), but example embodiments are not limited thereto. For example, the angle of the side wall relative to the bottom surface of the gate trench 160 may be an oblique angle.

The gate trench 160 may extend in the second direction (Y direction). A semiconductor device according to an embodiment may include a plurality of gate trenches 160 extending lengthwise in a second direction (Y direction). That is, the gate trench 160 may be provided in multiple numbers and may extend lengthwise in the second direction (Y direction). Each of the plurality of gate trenches 160 may extend in a direction parallel to one another. A plurality of gate trenches 160 may be arranged spaced apart from each other in the first direction (X direction).

In some embodiments, each of the plurality of gate trenches 160 may include a bottom surface and sidewalls extending from the bottom surface. The bottom surface of each of the plurality of gate trenches 160 may be defined by a first conductivity type semiconductor layer 131. The sidewalls of each of the plurality of gate trenches 160 may be defined by a first conductivity type semiconductor layer 131, a second conductivity type doped well region 133, and a first conductivity type doping pattern 300_2.

In some embodiments, the gate electrode 150_1 may be positioned within the gate trench 160 of the first conductivity type semiconductor layer 131. The gate electrode 150_1 may be spaced apart from the first conductivity type semiconductor layer 131. The gate electrode 150_1 may be spaced apart from the first conductivity type semiconductor layer 131 at a substantially constant interval. But example embodiments are not limited thereto, and the distance between the gate electrode 150_1 and the first conductivity type semiconductor layer 131 may vary depending on the location. The gate electrode 150_1 may have a cross-sectional shape similar to that of the gate trench 160. The gate electrode 150_1 may include a lower surface and side surfaces extending from the lower surface, and the lower surface and side surfaces of the gate electrode 150_1 may be formed in a cross-section that is approximately U-shaped along the shape of the gate trench 160. The gate electrode 150_1 may further include an upper surface facing the lower surface, and side surfaces may connect between the lower surface and the upper surface. The lower surface of the gate electrode 150_1 may face the bottom surface of the gate trench 160. The side surfaces of the gate electrode 150_1 may face the side walls of the gate trench 160.

In some embodiments, the interlayer insulating layer 140_1 may be positioned on the bottom surface and sidewalls of the gate trench 160. The interlayer insulating layer 140_1 may be positioned with a substantially uniform thickness on the bottom surface and side walls of the gate trench 160. Therefore, the distance between the gate electrode 150_1 and the first conductivity type semiconductor layer 131 may be almost constant.

The semiconductor device according to some embodiments may further include a dummy pattern 139 positioned within the first conductivity type doping pattern 300_2.

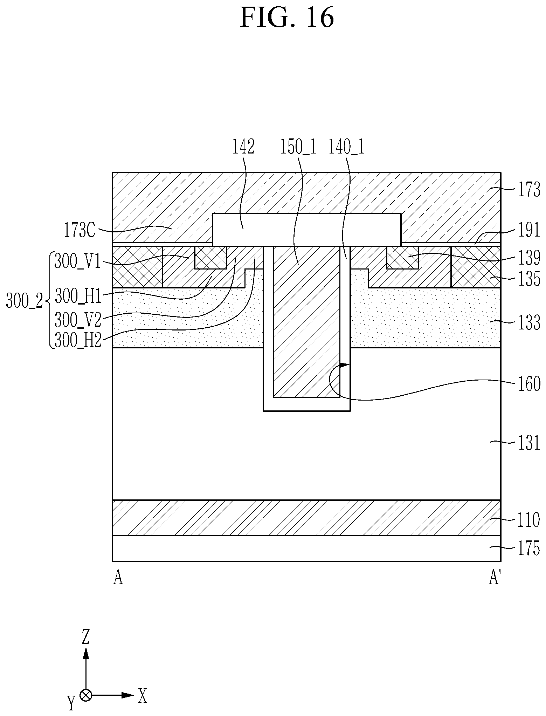

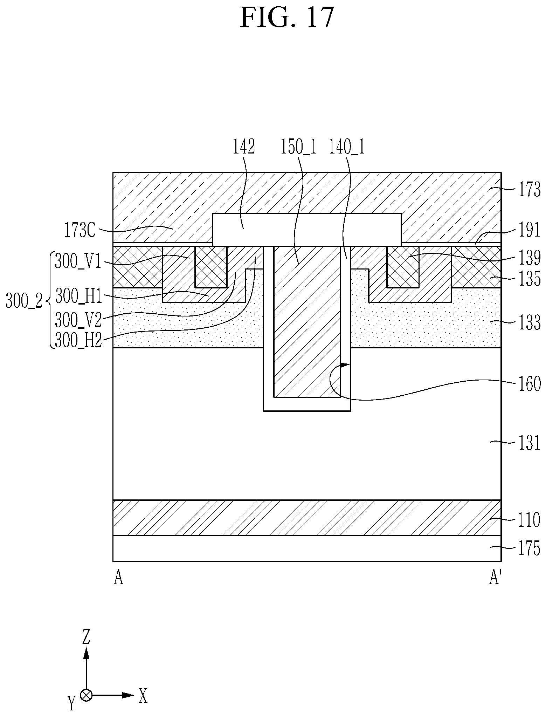

In some embodiments, the dummy pattern 139 may extend in a third direction (Z direction) from the upper surface of the first conductivity type semiconductor layer 131. For example, as illustrated in FIGS. 15 and 16, the thickness of the dummy pattern 139 in the third direction (Z direction) may be less than the thickness of the second conductivity type doped layer 135 in the third direction (Z direction). In this case, the thickness of the first conductivity type doping pattern 300_2 in the third direction (Z direction) may be less than the thickness of the second conductivity type doped layer 135 in the third direction (Z direction). But example embodiments are not limited thereto, and as illustrated in FIG. 17, the thickness of the dummy pattern 139 in the third direction (Z direction) may be substantially the same as the thickness of the second conductivity type doped layer 135 in the third direction (Z direction). In this case, the thickness of the first conductivity type doping pattern 300_2 in the third direction (Z direction) may be greater than the thickness of the second conductivity type doped layer 135 in the third direction (Z direction). The remaining description of the dummy pattern 139 is substantially the same as the description of the dummy pattern 139 of the embodiments of FIGS. 13 and 14, and therefore will be omitted.

In some embodiments, the first conductivity type doping pattern 300_2 may connect between the contact portion 173C and the second conductivity type doped well region 133. The first conductivity type doping pattern 300_2 may overlap the gate electrode 150_1 in the first direction (X direction). The first conductivity type doping pattern 300_2 does not overlap the gate electrode 150_1 in the third direction (Z direction).

In some embodiments, as illustrated in FIG. 15, the first conductivity type doping pattern 300_2 may include a first vertical portion 300_V1 overlapping the contact portion 173C in the third direction (Z direction), a second vertical portion 300_V2 positioned adjacent to the gate electrode 150_1, and a horizontal portion 300_H connecting the first vertical portion 300_V1 and the second vertical portion 300_V2. The second vertical portion 300_V2 may be positioned between the dummy pattern 139 and the interlayer insulating layer 140_1. The first vertical portion 300_V1 may be electrically connected to the contact portion 173C. The second vertical portion 300_V2 may be positioned on one side of the gate electrode 150_1. The second vertical portion 300_V2 does not overlap the contact portion 173C in the third direction (Z direction). In some embodiments, the dummy pattern 139 may be positioned between the first vertical portion 300_V1 and the second vertical portion 300_V2.

In some embodiments, as illustrated in FIG. 16, the first conductivity type doping pattern 300_2 may include a first horizontal portion 300_H1 connecting the first vertical portion 300_V1 and the second vertical portion 300_V2 and a second horizontal portion 300_H2 positioned between the second vertical portion 300_V2 and the interlayer insulating layer 140_1. The first horizontal portion 300_H1 may be positioned between the dummy pattern 139 and the second conductivity type doped well region 133, and the first vertical portion 300_V1 may be positioned between the capping layer 142 and the second conductivity type doped well region 133.

According to some embodiments, a semiconductor device may have a path for driving current formed sequentially from a contact portion 173C through a first vertical portion 300_V1, a horizontal portion 300_H, and a second vertical portion 300_V2 of a first conductivity type doping pattern 300_2 to a channel region of a second conductivity type doped well region 133. Accordingly, within a range where the distance between the gate electrode 150_1 and the contact portion 173C is not changed, the resistance value of the first conductivity type doping pattern 300_2 may increase, and the size of the driving current flowing through the first conductivity type doping pattern 300_2 may decrease. Therefore, the reliability of the semiconductor device may be improved by reducing the size of the driving current within a range that does not change the size of the transistor device.

Although the embodiments have been described in detail above, the scope of the present disclosure is not limited thereto, and various modifications and improvements made by those skilled in the art using the basic concept of the present disclosure defined in the following claims also fall within the scope of the present disclosure.

Embodiments are set out in the following clauses:
Clause 1. A semiconductor device comprising:
   a substrate including a first surface and a second surface opposite to each other;
   a first conductivity type semiconductor layer positioned on the first surface of the substrate;
   a second conductivity type doped well region positioned within the first conductivity type semiconductor layer;
   a first conductivity type doping pattern positioned within the second conductivity type doped well region;
   a gate electrode positioned on the first conductivity type semiconductor layer;
   a gate insulating layer positioned between the first conductivity type semiconductor layer and the gate electrode;
   a source electrode including a contact portion positioned on the second conductivity type doped well region; and
   a drain electrode positioned on the second surface of the substrate,
   wherein the first conductivity type doping pattern includes:
      a first portion overlapping the contact portion of the source electrode and extending in a first direction,
      a second portion overlapping the gate electrode and extending in the first direction, and
      a third portion connecting the first portion and the second portion and extending in a second direction intersecting the first direction, and
   wherein a sum of lengths of the first portion in the first direction, the second portion in the first direction, and the third portion in the second direction is greater than a length of the source electrode in the second direction.
Clause 2. The semiconductor device of clause 1,
   wherein a width of the first portion in the second direction is less than the length of the source electrode in the second direction.
Clause 3. The semiconductor device of clause 1 or clause 2,
   wherein a width of the second portion in the second direction is less than a length of the gate electrode in the second direction.
Clause 4. The semiconductor device of any of clauses 1-3,
   wherein the second portion does not overlap the gate electrode and the contact portion in a third direction perpendicular to the first and second directions.

### <Description of some symbols>

110: Substrate
131: First conductivity type semiconductor layer
133: Second conductivity type doped well region
140: Interlayer insulating layer
150: Gate electrode
173: Source electrode
175: Drain electrode
300: First conductivity type doping pattern

## Claims

1. A semiconductor device comprising:
a substrate (110) including a first surface and a second surface opposite to each other;
a first conductivity type semiconductor layer (131) positioned on the first surface of the substrate (110);
a second conductivity type doped well region (133) positioned within the first conductivity type semiconductor layer (131);
a gate electrode (150) positioned on the first conductivity type semiconductor layer (131);
a gate insulating layer (151) positioned between the first conductivity type semiconductor layer (131) and the gate electrode (150);
a first conductivity type doping pattern (300) positioned within the second conductivity type doped well region (133);
a source electrode (173) positioned on the second conductivity type doped well region (133) and including a contact portion (173C) electrically connected to the first conductivity type doping pattern (300); and
a drain electrode (175) positioned on the second surface of the substrate (110),
wherein the first conductivity type doping pattern (300) includes:
a first portion (310) extending in a first direction (X) and overlapping the contact portion (173C) of the source electrode (173),
a second portion (320) extending in the first direction (X) and positioned adjacent to the gate electrode (150), and
a third portion (330) connecting the first portion (310) and the second portion (320), and
wherein a width (W1) in a second direction (Y) of the first portion (310) is less than a length (D1) of the contact portion (173C) in the second direction (Y), or a width (W2) in the second direction (Y) of the second portion (320) is less than a length (D1) in the second direction (Y) of the gate electrode (150), the second direction (Y) being perpendicular to the first direction (X).

2. The semiconductor device of claim 1,
wherein the second portion (320) overlaps the gate electrode (150) in a third direction (Z) perpendicular to the first and second directions (X, Y), and
wherein the first portion (310) and the third portion (320) do not overlap the gate electrode (150) in the third direction (Z).

3. The semiconductor device of claim 2,
wherein the second portion (320) and the third portion (330) do not overlap the contact portion (173C) in the third direction (Z).

4. The semiconductor device of any preceding claim,
wherein an extended length (DD) of the first conductivity type doping pattern (300) is greater than the length (D1) of the contact portion (173C), and
wherein the extended length (DD) of the first conductivity doping pattern (300) includes a length of the first portion (310) in the first direction (X), a length of the second portion (320) in the first direction (X), and a length of the third portion (330) in the second direction (Y).

5. The semiconductor device of claim 4,
wherein the first conductivity type doping pattern (300) includes at least one bent portion in a plan view.

6. The semiconductor device of any preceding claim,
wherein the third portion (330) extends in the second direction (Y) intersecting the first direction (X).

7. The semiconductor device of claim 6,
wherein a width (W3) of the third portion (330) in the first direction (X) is less than a distance between the contact portion (173C) and the gate electrode (150).

8. The semiconductor device of any preceding claim,
wherein the contact portion (173C) extends in the first direction (X), and
wherein the width (W1) of the first portion (310) in the second direction (Y) is less than the length (D1) of the contact portion (173C) in the second direction (Y).

9. The semiconductor device of any preceding claim,
wherein the gate electrode (150) extends in the second direction (Y), and
wherein the width (W2) of the second portion (320) in the second direction (Y) is less than the length (D2) of the gate electrode (150) in the second direction (Y).

10. The semiconductor device of any preceding claim,
wherein the width (W1) of the first portion (310) in the second direction (Y) is different from the width (W2) of the second portion (320) in the second direction (Y).

11. The semiconductor device of any preceding claim, further comprising:
a second conductivity type doped layer (135) positioned between the second conductivity type doped well region (133) and the contact portion (173C),
wherein the second conductivity type doped well region (133) includes a patterned portion (133PP) positioned between the second conductivity type doped layer (135) and the third portion (330).

12. The semiconductor device of claim 11,
wherein the patterned portion (133PP) and the contact portion (173C) extend in the second direction (Y), and
wherein a length of the patterned portion (133PP) in the second direction (Y) is less than the length of the contact portion (173C) in the second direction (Y).

13. The semiconductor device of claim 11 or claim 12, further comprising:
a silicide layer (190) positioned between the contact portion (173C) and the first portion (310),
wherein the upper surface of the patterned portion (133PP) is in contact with the silicide layer (190).

14. The semiconductor device of any preceding claim,
wherein the second conductivity type doped well region (133) is positioned on opposite sides of the third portion (330).

15. The semiconductor device of any preceding claim,
wherein the third portion (330) extends in a direction parallel to the gate electrode (150).
